# EUROPÄISCHE PATENTANMELDUNG

(11) **EP 0 631 301 A1**
(43) Veröffentlichungstag der Anmeldung: **28.12.1994**
(21) Anmeldenummer: 94109103.5
(22) Anmeldetag: 14.06.1994
(51) Int. Cl.: H01L 21/329, H01L 21/306

(54) **Herstellverfahren für ein Leistungshalbleiterbauelement für hohe Abkommutierungssteilheit**

(30) Priorität: 21.06.1993 DE 4320560
(71) Anmelder: EUPEC Europäische Gesellschaft für Leistungshalbleiter mbH & Co. KG, D-59581 Warstein (DE)
(72) Erfinder: Pikorz, Wolfgang, Dipl.-Ing., D-59581 Warstein (DE); Sonntag, Alois, Dipl.-Phys., D-59581 Warstein (DE)
(74) Vertreter: Fuchs, Franz-Josef, Dr.-Ing.

(57) **Zusammenfassung**

Die zerstörungsfreie Abkommutierungssteilheit von Leistungshalbleiterbauelementen läßt sich erheblich erhöhen, wenn der sperrende pn-Übergang von einer polierten Oberfläche des Halbleiterkörpers aus erzeugt wird. Damit wird der pn-Übergang so homogen, daß lokale Überlastungen vermieden werden, wodurch die Abkommutierungssteilheit erhöht werden kann.

## Beschreibung

Die Erfindung betrifft ein Verfahren zum Herstellen eines Leistungshalbleiterbauelements mit mindestens einer ebenen Oberfläche und mit einem Halbleiterkörper mit mindestens zwei Zonen vom ersten bzw. zweiten Leistungstyp.

Solche Leistungshalbleiterbauelement können z.B. Dioden oder auch Thyristoren sein. Dioden werden nicht nur als ungesteuerte Gleichrichter verwendet, sondern in zunehmendem Maß als Freilauf- oder Beschaltungsdioden in Stromrichterschaltungen eingesetzt. In solchen Schaltungen übernebmen sie in der Abschaltphase den von einer induktiven Last aufgezwungenen Strom. Da dieser Strom im Interesse einer hohen Schaltgeschwindigkeit schnell abkommutiert werden soll, entsteht an der induktiven Last eine hohe Spannung, die auch an der Diode anliegt. Da hier gleichzeitig ein hoher Strom fließt, kommt es zu hohen Verlusten in der Diode, wodurch diese zerstört werden kann.

Der Erfindung liegt die Aufgabe zugrunde, ein Leistungshalbleiterbauelement der genannten Art derart weiterzubilden, daß die genannten Belastungen erhöht werden können, ohne daß das Halbleiterbauelement zerstört wird.

Diese Aufgabe wird dadurch gelöst, daß ein Halbleiterkörper des ersten Leitungstyps mindestens auf einer seiner ebenen Oberflächen poliert wird und daß die Zone des zweiten Leitungstyps ausgehend von dieser Oberfläche erzeugt wird.

Weiterbildungen der Erfindung sind Gegenstand der Unteransprüche.

Die Erfindung geht von der Erkenntnis aus, daß durch die üblichen Bearbeitungsverfahren der Oberfläche von Leistungshalbleiterbauelementen wie Schleifen oder Läppen in diesen Oberflächen Kristallstörungen erzeugt werden. Werden ausgehend von einer solchen gestörten Oberfläche Dotierstoffe in den Halbleiterkörper diffundiert, so entsteht ein inhomogener pn-Übergang. Diese Inhomogenitäten sind die Ursache für die oben erwähnten Überlastungen und Ausfälle der Dioden. Es ist auch denkbar, daß sie in ähnlicher Weise für die Zerstörung von hinsichtlich der Dicke knapp dimensionierten Thyristoren wie z.B. asymmetrischen Thyristoren, verantwortlich sind.

Die Erfindung wird anhand einiger Ausführungsbeispiele in Verbindung mit den Figuren 1a bis 4b näher erläutert. Dabei zeigt
- Figur 1a bis 1e: charakteristische Verfahrensschritte eines ersten Ausführungsbeispiels
- Figur 2a bis 2c: charakteristische Verfahrensschritte eines zweiten Ausführungsbeispiels
- Figur 3a und 3b: eine fakultative Weiterbildung der Schritte nach Figur 2a bis 2c und
- Figur 4a und 4b: charakteristische Verfahrensschritte gemäß einem vierten Ausführungsbeispiel.

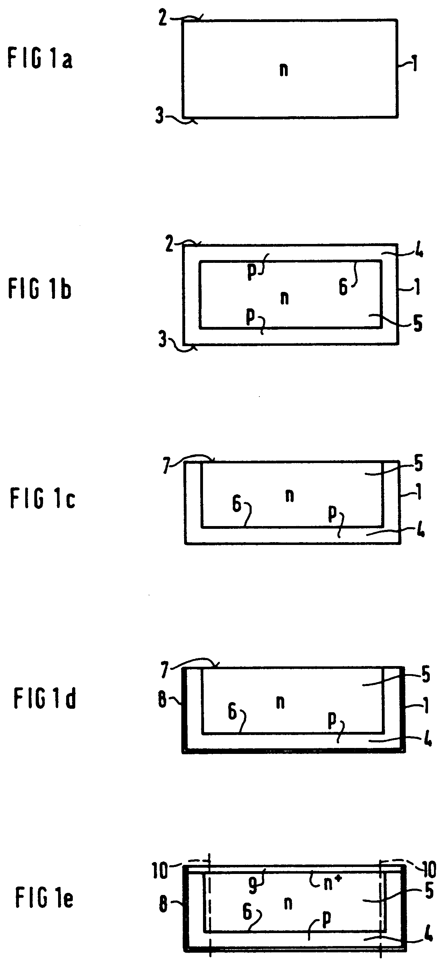

In Figur 1a ist ein n-dotierter Halbleiterkörper mit 1 bezeichnet. Er hat eine obere Oberfläche 2 und eine untere Oberfläche 3. Die Oberfläche 2 wird wie üblich bearbeitet, z.B. geläppt und geätzt. Die Oberfläche 3 hingegen wird poliert. Dieses Polieren ist aus der Herstellung von Halbleiterscheiben für integrierte Halbleiter bekannt. Es führt zu einer spiegelnden Oberfläche mit einer mittleren Abweichung von weniger als 0,1µm. Als nächster Schritt (Figur 1b) wird in den Halbleiterkörper 1 allseitig eine p-dotierende Substanz, beispielsweise Bor eindiffundiert. Dabei entsteht eine p-dotierte Zone 4, eine n-dotierte Zone 5 bleibt übrig. Zwischen beiden Zonen liegt ein pn-Übergang 6, der auf der der polierten Oberfläche 3 benachbarten Seite in hohem Maße homogen und im wesentlichen störungsfrei ist. Beim nächsten Schritt (Figur 1c) wird der auf der der Oberfläche 2 benachbarte Teil der p-dotierten Zone 4 z.B. durch Schleifen, Läppen oder Ätzen entfernt. Dabei entsteht eine Oberfläche 7. In die Oberfläche 7 wird nun n-dotierendes Material eindiffundiert, nachdem die restliche Oberfläche des Halbleiterkörpers 1 mit einer Oxidmaske 8 (Figur 1d) versehen wurde. Dabei entsteht eine stark n-dotierte Zone 9 (Figur 1e), die im wesentlichen der Kontaktierung dient. Als letzter Verfahrensschritt wird der Randbereich der p-dotierten Zone 4 mechanisch und chemisch entlang der gestrichelten Linien 10 entfernt. Damit entsteht eine Mesastruktur. Da die stark n-dotierte Zone 9 von der relativ stark gestörten Oberfläche 7 aus erzeugt wurde, ist der zwischen den Zonen 5 und 9 liegende nn⁺-Übergang relativ inhomogen.

Alternativ kann die Oberfläche 7 nach dem Schleifen und Ätzen wie die Oberfläche 3 poliert werden. Dann wird auch der nn⁺-Übergang zwischen den Zonen 5 und 9 homogen und im wesentlichen störungsfrei.

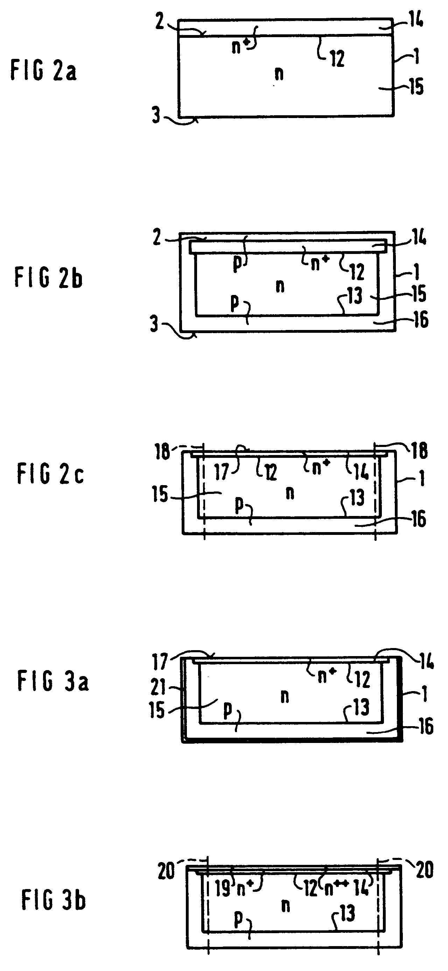

Im zweiten Ausführungsbeispiel (Figur 2a bis 2c) ist der n-dotierte Halbleiterkörper wieder mit 1 bezeichnet. Hier werden die obere Oberfläche 2 und die untere Oberfläche 3 poliert. Anschließend wird auf die Oberfläche 2 eine stark n-dotierte Epitaxieschicht 14 erzeugt. Beim nächsten Schritt (Figur 2b) wird in den Halbleiterkörper einschließlich der Zone 14 allseitig p-dotierendes Material eindiffundiert. Dabei entsteht eine p-dotierte Zone 16 und auch die Zone 14 diffundiert etwas in die Zone 15 und die p-dotierte Schicht 16 hinein. Als nächstes wird der auf der Seite der Epitaxieschicht 14 liegende Teil der p-Zone 16 entfernt. Dabei entsteht eine Oberfläche 17. Danach wird der Randbereich der p-dotierten Zone 16 entlang der gestrichelten Linien 18 entfernt, so daß wiederum eine Mesastruktur mit der Zonenfolge n⁺np entsteht (Figur 2c).

Fakultativ können sich an den Schritt gemäß Figur 2c anstelle der Abtrennung entlang der gestrichelten Linie 18 zwei weitere Schritte anschließen, die in Figur 3a und 3b dargestellt sind. So kann in die Oberfläche 17 n-dotierendes Material eindiffundiert werden, so daß eine stark n-dotierte Zone 19 entsteht, die sich an die n-dotierte Schicht 14 anschließt. Dazu wird der Halbleiterkörper an den beiden Seiten und an der Unterseite mit einer Oxidmaske 21 versehen. Anschließend kann der Halbleiterkörper 1 durch senkrechte Schnitte entlang der gestrichelten Linien 20 in eine Mesastruktur umgewandelt werden.

Bei den Ausführungsformen nach Figur 2 und 3 entsteht sowohl ein sehr homogener pn-Übergang als auch ein sehr homogener nn⁺-Übergang.

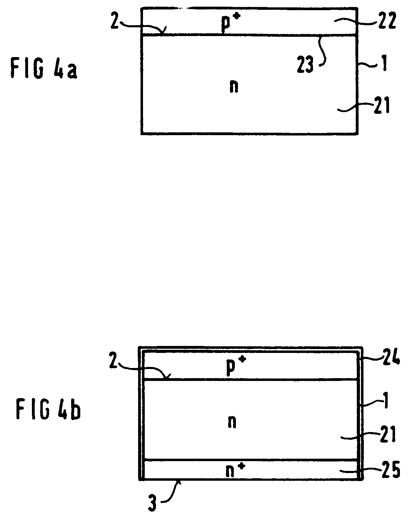

Anstelle der n-dotierten Epitaxieschicht kann auch auf der polierten Oberfläche 2 eine p-dotierte Epitaxieschicht 22 (Figur 4a) erzeugt werden. Dabei bildet die Oberfläche 2 einen pn-Übergang 23 zwischen der Epitaxiezone 22 und der unverändert gebliebenen Zone 21 des Halbleiterkörpers 1. Anschließend wird in die Oberfläche 3 stark n-dotierendes Material eindiffundiert. Der Randbereich und die Oberseite des Halbleiterkörpers werden dabei durch eine Oxidmaske 24 geschützt. Die Oberfläche 3 kann hierbei entweder poliert oder geläppt und geätzt sein, so daß entweder ein homogener, im wesentlichen ungestörter Übergang zwischen den Zonen 21 und 25 erzeugt wird oder ein mehr inhomogener Übergang. Für manche Anwendungszwecke reicht ein imhomogener nn⁺-Übergang aus. Vorteilhaft ist es jedoch, beide Übergänge ausgehend von einer polierten Oberfläche zu erzeugen.

Ausführungsbeispiel: Dioden mit einem Durchmesser von 23mm und einer Sperrspannung V_{RM} von 1700 V wurden mit einer Steilheit von 1200 A/µs abkommutiert. Dieses Abkommutieren überstanden 90 % der Dioden zerstörungsfrei.

## Patentansprüche

1. Verfahren zum Herstellen eines Leistungshalbleiterbauelements mit einem Halbleiterkörper mit mindestens einer ebenen Oberfläche und mit mindestens zwei Zonen vom ersten bzw. zweiten Leitungstyp,
**dadurch gekennzeichnet,** daß ein Halbleiterkörper (1) des ersten Leitungstyps mindestens auf einer seiner ebenen Oberflächen (2, 3) poliert wird und daß die Zone (4, 14) des zweiten Leitungstyps ausgehend von dieser Oberfläche erzeugt wird.

2. Verfahren nach Anspruch 1,
**dadurch gekennzeichnet,** daß die Zone (14) des zweiten Leitungstyps durch epitaktisches Aufwachsen auf der polierten Oberfläche (12) erzeugt wird.

3. Verfahren nach Anspruch 1,
**dadurch gekennzeichnet,** daß die Zone (4) des zweiten Leitungstyps durch Eindiffusion ausgehend von der polierten Oberfläche (2) erzeugt wird.

4. Verfahren nach einem der Ansprüche 1 bis 3,
**dadurch gekennzeichnet,** daß auch die andere Oberfläche (3) des Halbleiterkörpers poliert wird und daß ausgehend von der anderen polierten Oberfläche eine dritte Zone durch epitaktisches Aufwachsen erzeugt wird.

5. Verfahren nach einem der Ansprüche 1 bis 3,
**dadurch gekennzeichnet,** daß auch die andere Oberfläche (3) des Halbleiterkörpers poliert wird und daß ausgehend von der anderen polierten Oberfläche durch Eindiffusion eine dritte Zone erzeugt wird.

6. Verfahren nach Anspruch 4 oder 5,
**dadurch gekennzeichnet,** daß die dritte Zone vom ersten Leitungstyp und höher dotiert ist als der ursprüngliche Halbleiterkörper.

7. Verfahren nach Anspruch 4 oder 5,
**dadurch gekennzeichnet,** daß die dritte Zone vom zweiten Leitungstyp ist.

8. Verfahren nach einem der Ansprüche 1 bis 7,
**dadurch gekennzeichnet,** daß die ebene Oberfläche spieglend poliert wird mit einer mittleren Abweichung von weniger al 0,1 µm.
